# EUROPEAN PATENT APPLICATION

(11) **EP 1 988 641 A1**
(43) Date of publication of application: **05.11.2008**
(21) Application number: 07742145.1
(22) Date of filing: 23.04.2007
(51) Int. Cl.: H04B 1/18, H01Q 23/00

(54) **ANTENNA DEVICE AND ELECTRONIC DEVICE USING THE SAME**

(30) Priority: 27.04.2006 JP 2006123211
(71) Applicant: Matsushita Electric Industrial Co., Ltd., Kadoma-shi Osaka 571-8501 (JP)
(72) Inventor: OZAKI, Akihiro c/o Matsushita El.Ind.Co.Ltd., 2-1-61, Shiromi. Chuo-ku, Osaka 540-6207 (JP); OKAYAMA, Motoyuki c/o Matsushita El.Ind.Co.Ltd., 2-1-61, Shiromi, Chuo-ku, Osaka 540-6207 (JP); HOSHIAI, Akihiro c/o Matsushita El.Ind.Co.Ltd., 2-1-61, Shiromi, Chuo-ku, Osaka 540-6207 (JP); SAKO, Motohiko c/o Matsushita Elo.Ind.Co.Ltd., 2-1-61, Shiromi, Chuo-ku, Osaka 540-6207 (JP); SATOH, Yuki c/o Matsushita El.Ind.Co.Ltd, 2-1-61, Shiromi, Chuo-ku, Osaka 540-6207 (JP)
(74) Representative: Schwabe - Sandmair - Marx
(86) International application number: PCT/JP2007/058710
(87) International publication number: WO 2007/125850

(57) **Abstract**

The antenna device has an antenna element, a transistor circuit connected to the antenna element, and an inductance circuit earthed to a shunt between the antenna element and the transistor circuit. The electronic device has the antenna device and a radio circuit connected to the transistor circuit.

## Description

### TECHNICAL FIELD

The present invention relates to an antenna device as a single-piece construction of an antenna element and a transistor circuit, and also relates to an electronic device using the antenna device.

### BACKGROUND ART

An antenna device, which is an antenna element and a transistor circuit combined in one unit, has a shorter antenna-element length with respect to a wavelength. Such structured antenna device, even it has a compact structure, can suppress impedance-mismatch loss and serves as a wide-band antenna device.

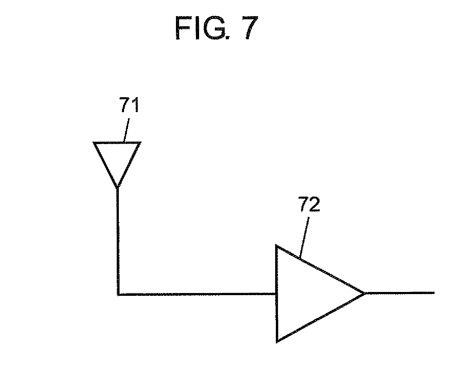

Hereinafter, a conventional antenna device will be described with reference to Fig. 7. The antenna device of Fig. 7 has antenna element 71 and transistor circuit 72 that is connected directly or via a lead and a matching circuit to transistor circuit 72.

However, making shorter the antenna-element length of the conventional device above allows antenna element 71 to have high capacitive output-impedance. Connecting such antenna element 71 to transistor circuit 72 having capacitive input-impedance has a difficultly in matching impedance between antenna element 71 and transistor circuit 72. The connection of them causes impedance mismatch in high-frequency bands, degrading radiation efficiency and receiving performance of the antenna device. The problem has been an obstacle to offer an antenna device with radiation efficiency and receiving performance in a wide frequency band.

For example, non-patent document 1 and patent document 1 below are known as the prior-art references relating to the present invention.
non-patent document 1: Antenna Kougaku Handbook (pp.45-46), The Institute of Electronics, Information and Communication Engineers, Ohmsha, 1980
patent document 1: Japanese Unexamined Patent Application Publication No. H10-303640

### SUMMERY OF THE INVENTION

The antenna device has an antenna element, a transistor circuit connected to the antenna element, and an inductance circuit earthed to a shunt between the antenna element and the transistor circuit. In a first frequency band, the output impedance of the antenna element is capacitive and the input impedance of the transistor circuit via the inductance circuit is inductive. Besides, the output impedance of the antenna element and the input impedance of the transistor circuit via the inductance circuit are substantially in a complex conjugate relation. In a second frequency band higher than the first frequency band, the output impedance of the antenna element is inductive and the input impedance of the transistor circuit via the inductance circuit is capacitive. Besides, the output impedance of the antenna element and the input impedance of the transistor circuit via the inductance circuit are substantially in a complex conjugate relation.

The electronic device has an antenna element, a transistor circuit connected to the antenna element, an inductance circuit earthed to a shunt between the antenna element and the transistor circuit, and a radio circuit connected to the transistor circuit. In a first frequency band, the output impedance of the antenna element is capacitive and the input impedance of the transistor circuit via the inductance circuit is inductive. Besides, the output impedance of the antenna element and the input impedance of the transistor circuit via the inductance circuit are substantially in a complex conjugate relation. In a second frequency band higher than the first frequency band, the output impedance of the antenna element is inductive and the input impedance of the transistor circuit via the inductance circuit is capacitive. Besides, the output impedance of the antenna element and the input impedance of the transistor circuit via the inductance circuit are substantially in a complex conjugate relation.

### BRIEF DESCRIPTION OF THE DRAWINGS

Fig. 1 is a circuit diagram of an antenna device in accordance with an exemplary embodiment of the present invention.
Fig. 2 is a circuit diagram of an electronic device using the antenna device of the embodiment.
Fig. 3 shows a structure of the antenna device of the embodiment.
Fig. 4 shows another structure of the antenna device of the embodiment.
Fig. 5 is another circuit diagram of the antenna device of the embodiment.
Fig. 6 is still another circuit diagram of the antenna device of the embodiment.
Fig. 7 is a circuit diagram of a conventional antenna device.

### REFERENCE MARKS IN THE DRAWINGS

- 10: antenna device
- 11: antenna element
- 12: transistor circuit
- 13: inductance circuit
- 14: varistor
- 15: first diode
- 16: second diode
- 21: radio circuit
- 22: electronic device
- 111, 114: feeder section
- 112: first conductor
- 113: second conductor
- 115: feeder element
- 116: parasitic element

### DETAILED DESCRIPTION OF THE PREFERRED EMBODIMENTS

### (EXEMPLARY EMBODIMENT)

The present invention provides an antenna device capable of enhancing radiation and receiving characteristics over a wide band, and also provides an electronic device using the antenna device.

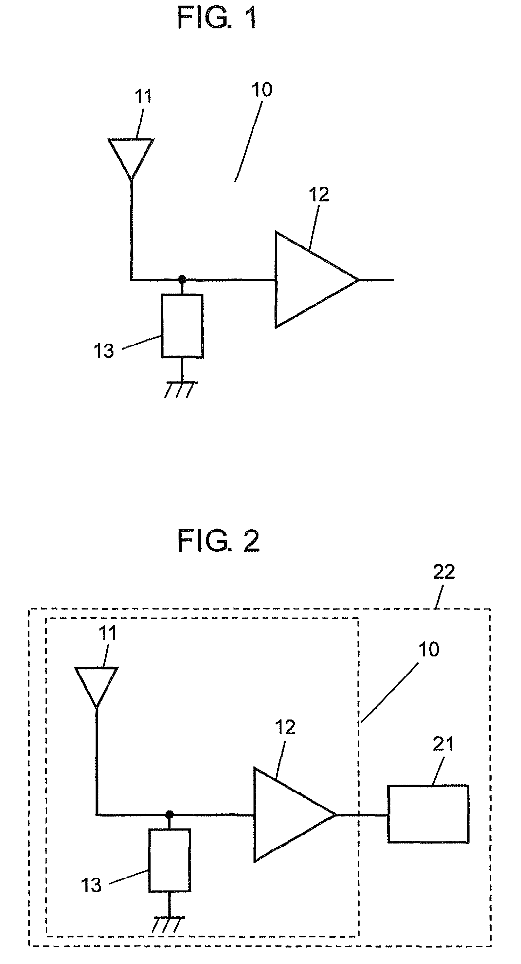

Hereinafter, an embodiment of the present invention will be described with reference to Fig. 1 through Fig. 6.

Fig. 1 is a circuit diagram of the antenna device in accordance with an exemplary embodiment of the present invention. Antenna device 10 of Fig. 1 has antenna element 11, transistor circuit 12, and inductance circuit 13. Antenna element 11 is connected to transistor circuit 12. One terminal of inductance circuit 13 is connected to the connecting point of antenna element 11 and transistor circuit 12, and the other terminal of inductance circuit 13 is earthed. That is, inductance circuit 13 is earthed to a shunt between antenna element 11 and transistor circuit 12. Transistor circuit 12 is formed of a semiconductor and various types of electronic components. Transistor circuit 12 has, for example, a "front-end" function.

Although Fig. 1 shows antenna device 10 on a receiving system, it is not limited thereto. The antenna device of the present invention is applicable to a transmitting system. When the antenna device is applied to a transmitting system, for example, a high-frequency amplifier is employed for transistor circuit 12.

Fig. 2 shows electronic device 22 equipped with antenna device 10 of Fig. 1. In Fig. 2, radio circuit 21 is connected to transistor circuit 12. Receiving an output signal from transistor circuit 12, radio circuit 21 carries out predetermined signal processing: tuning, amplifying, frequency conversion; demodulating; filtering; and signal separation. Although Fig. 2 shows the structure of electronic device 22 on a receiving system, it is not limited thereto. Electronic device 22 of the present invention is applicable to a transmitting system. When the electronic device is applied to a transmitting system, radio circuit 21 carries out, for example, signal synthesizing, signal multiplexing, filtering, modulating, frequency conversion, and amplifying.

The element length of antenna element 11 is adjusted so that the output impedance is capacitive in a first frequency band, i.e., in the lower-limit region in the receiving frequency band, and the output impedance is inductive in a second frequency band, i.e., in the upper-limit region in the receiving frequency band. That is, in general, the element length of antenna element 11 is not less than one-fourth the wavelength of a signal in the second frequency band and not more than one-fourth the wavelength of a signal in the first frequency band. When the element length of antenna element 11 satisfies the conditions above, the resonance frequency of antenna element 11 is between the first frequency band and the second frequency band.

Although the paragraph above explained that the element length of antenna element 11 is not less than (or not more than) one-fourth, it is not limited thereto. The 'one-fourth the wavelength' can be replaced with the 'odd-numbered multiples of one-fourth the wavelength'. That is, when antenna element 11 has an element length that is not less than odd-numbered multiples of one-fourth the wavelength of a signal in the second frequency band and that is not more than odd-numbered multiples of one-fourth the wavelength of a signal in the first frequency band, the structure is also able to offer the advantage and effect of the present invention.

Transistor circuit 12 is formed of, for example, a common-emitter type transistor or a common-collector type transistor. An equivalent circuit of the input section of transistor circuit 12 is a capacitance circuit earthed to a shunt. On the other hand, inductance circuit 13 is earthed to a shunt between antenna element 11 and transistor circuit 12. That is, an equivalent circuit on the output-side of antenna element 11 is formed of the capacitance circuit and inductance circuit 13, which are earthed to a shunt and connected in parallel with each other.

In the structure above, the output impedance of antenna element 11 is adjusted to be capacitive in the first frequency band, while the input impedance of transistor circuit 12 via inductance circuit 13 is adjusted to be inductive. Besides, the output impedance of antenna element 11 and the input impedance of transistor circuit 12 via inductance circuit 13 are substantially in a complex conjugate relation. In the second frequency band higher than the first frequency band, the output impedance of antenna element 11 is adjusted to be inductive, while the input impedance of transistor circuit 12 via inductance circuit 13 is adjusted to be capacitive. Besides, the output impedance of antenna element 11 and the input impedance of transistor circuit 12 via inductance circuit 13 are substantially in a complex conjugate relation.

Here will be given detailed description of antenna device 10 of the embodiment.

In the first frequency band, i.e., in the lower-limit region of the receiving frequency band, the output impedance of antenna element 11 is adjusted to be capacitive, while the input impedance of transistor circuit 12 via inductance circuit 13 is adjusted to be inductive. Besides, the two impedances have a complex conjugate relation therebetween. The structure above establishes preferable impedance-matching between antenna element 11 and transistor circuit 12, thereby enhancing efficiencies in radiation and receiving of the antenna device.

A frequency range between the first frequency band and the second frequency band, although it is slightly outside the conjugate-matching range of antenna element 11 and transistor circuit 12, is close to the resonance frequency of antenna element 11 itself. Therefore, in the frequency range above, too, antenna element 11 offers improved efficiencies in radiation and receiving.

Furthermore, in the second frequency band, i.e., in the upper-limit region of the receiving frequency band, the output impedance of antenna element 11 is adjusted to be inductive, while the input impedance of transistor circuit 12 via inductance circuit 13 is adjusted to be capacitive. Besides, the two impedances have a complex conjugate relation therebetween. The structure above establishes preferable impedance-matching between antenna element 11 and transistor circuit 12, thereby enhancing efficiencies in radiation and receiving of the antenna device.

With the structure above, antenna device 10 receives/transmits signals over a wide band from the first frequency band where the output impedance of antenna element 11 is highly capacitive to the second frequency band where it is highly inductive.

Preferably, the output impedance of antenna element 11 should be larger than the input impedance of transistor circuit 12. The adjustment allows the output impedance at around resonance frequency of antenna element 11 to bring close to the input impedance of transistor circuit 12. This encourages antenna element 11 and transistor circuit 12 to easily establish impedance-matching therebetween.

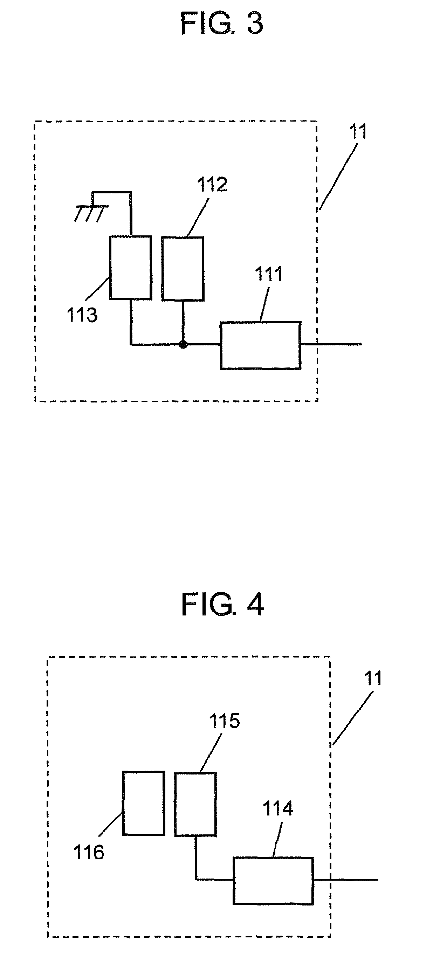

Fig. 3 shows a structure of antenna element 11 of the embodiment. Antenna element 11 of Fig. 3 has feeder section 111, first conductor 112, and second conductor 113. Antenna element 11 of the present invention may have such a folded structure shown in Fig. 3. Feeder section 111 is connected to transistor circuit 12, and first conductor 112 is connected to feeder section 111. Second conductor 113, whose one end is connected to first conductor 112 and the other is earthed, is disposed substantially parallel to first conductor 112 in spaced relation to each other. An antenna element with the folded structure has an output impedance four-times larger than an antenna element with a non-folded structure. By virtue of the folded structure, the output impedance at around the resonance frequency of antenna element 11 gets closer to the input impedance of transistor circuit 12. This encourages antenna element 11 and transistor circuit 12 to easily establish impedance-matching therebetween.

Fig. 4 shows another structure of antenna element 11 of the embodiment. Antenna element 11 of Fig. 4 has feeder section 114, feeder element 115, and parasitic element 116. Feeder section 114 is connected to transistor circuit 12. One end of feeder element 115 is connected to feeder section 114, and the other end is an open end. Both ends of parasitic element 116 are open ends. Feeder element 115 has an element length substantially the same as that of parasitic element 116. Having the same element length causes a multi-resonance between the first and the second frequency bands, increasing the output impedance of antenna element 11. This allows the output impedance at around the resonance frequency of antenna element 11 to bring closer to the input impedance of transistor circuit 12. This encourages antenna element 11 and transistor circuit 12 to easily establish impedance-matching therebetween.

Transistor circuit 12 should preferably be formed of a field-effect transistor (FET). An FET has considerably high input-impedance, which allows antenna element 11 and transistor circuit 12 to have conjugate matching at high impedance. As a result, the first frequency band can cover further lower range, and the second frequency band can cover further higher range. This allows antenna element 11 to have radiation and receiving characteristics over a wide band.

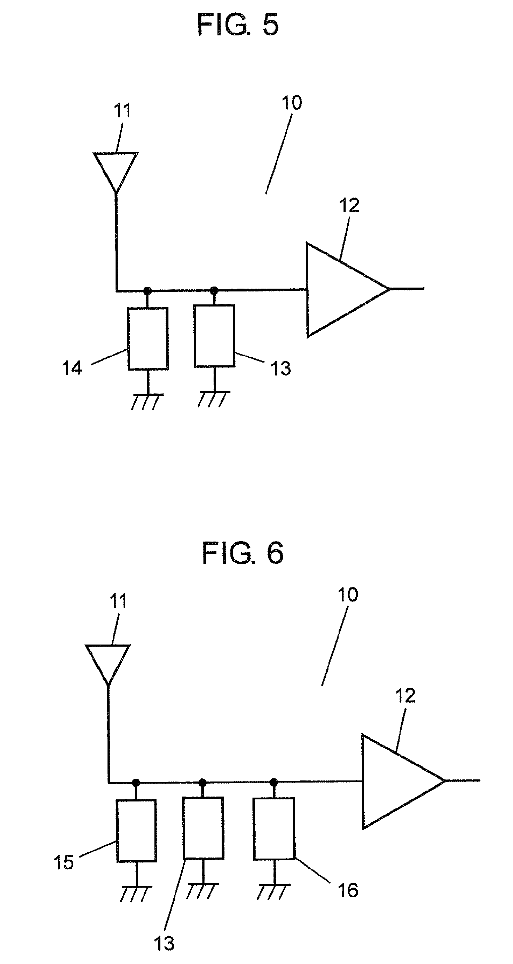

Fig. 5 is another circuit diagram of antenna device 10 of the embodiment. In Fig. 5, like parts are identified by the same reference numerals as in Fig. 1, and description thereof will be omitted. The structure of Fig. 5 differs from that of Fig. 1 in that varistor 14 is disposed in antenna device 10.

One terminal of varistor 14 is connected to the connecting point of antenna element 11 and transistor circuit 12, and the other terminal is earthed. That is, varistor 14 is connected in parallel to inductance circuit 13 and earthed to a shunt. The structure above protects transistor circuit 12 from damage caused by static electricity.

Fig. 6 is still another circuit diagram of antenna device 10 of the embodiment. In Fig.6, like parts are identified by the same reference numerals as in Fig. 1, and description thereof will be omitted. The structure of Fig. 6 differs from that of Fig. 1 in that first diode 15 and second diode 16 are disposed in antenna device 10.

First diode 15 is connected in parallel to inductance circuit 13. Second diode 16 is connected in parallel to first diode 15 so as to be opposite in polarity (i.e., in anode and cathode) to first diode 15. The structure above also protects transistor circuit 12 from damage caused by static electricity.

According to the antenna device of the present invention, as is apparent from the description above, the antenna element and the transistor circuit maintain preferable impedance-matching in the first frequency band where the output impedance of antenna element 11 is highly capacitive and in the second frequency band where it is highly inductive. Besides, the range between the first frequency band and the second frequency band is a region close to the resonance frequency of the antenna element. This allows antenna element 11 to have excellent efficiency in receiving and radiation. As a result, when receiving/transmitting signals, the antenna device of the present invention and an electronic device using the antenna device can cover a wide band ranging from the first frequency band where the output impedance of the antenna element is highly capacitive to the second frequency band where it is highly inductive.

### INDUSTRIAL APPLICABILITY

The antenna device of the present invention and an electronic device using the antenna device offer wide-band communications. It is therefore useful for mobile phones and other electronic devices.

## Claims

1. An antenna device comprising:
an antenna element;
a transistor circuit connected to the antenna element; and
an inductance circuit earthed to a shunt between the antenna element and the transistor circuit,
wherein, in a first frequency band, an output impedance of the antenna element is capacitive and an input impedance of the transistor circuit via the inductance circuit is inductive, and the output impedance of the antenna element and the input impedance of the transistor circuit via the inductance circuit are substantially in a complex conjugate relation,
in a second frequency band higher than the first frequency band, the output impedance of the antenna element is inductive and the input impedance of the transistor circuit via the inductance circuit is capacitive, and the output impedance of the antenna element and the input impedance of the transistor circuit via the inductance circuit are substantially in a complex conjugate relation.

2. The antenna device of claim 1, wherein a resonance frequency of the antenna element is between the first frequency band and the second frequency band.

3. The antenna device of claim 1, wherein an element length of the antenna element is not less than one-fourth a wavelength of a signal belonging to the second frequency band and not more than one-fourth a wavelength of a signal belonging to the first frequency band.

4. The antenna device of claim 1, wherein the output impedance of the antenna element is larger than the input impedance of the transistor circuit.

5. The antenna device of claim 1, wherein the antenna element includes:
a feeder section connected to the transistor circuit;
a first conductor connected to the feeder section; and
a second conductor whose one end is connected to the first conductor and other end is earthed, the second conductor substantially disposed in parallel to the first conductor at a certain interval.

6. The antenna device of claim 1, wherein the antenna element includes:
a feeder section connected to the transistor circuit;
a feeder element whose one end is connected to the feeder section and other end is an open end; and
a parasitic element whose both ends are open ends,
wherein, an element length of the parasitic element equals to an element length of the feeder element.

7. The antenna device of claim 1, wherein the transistor circuit is formed of a field-effect transistor.

8. The antenna device of claim 1 further comprising:
a varistor connected between the antenna element and the transistor circuit so as to be in parallel to the inductance circuit, and earthed to a shunt.

9. The antenna device of claim 1 further comprising:
a first diode connected between the antenna element and the transistor circuit so as to be in parallel to the inductance circuit; and
a second diode connected therebetween so as to be in parallel and opposite in polarity to the first diode.

10. An electronic device comprising:
an antenna element;
a transistor circuit connected to the antenna element;
an inductance circuit earthed to a shunt between the antenna element and the transistor circuit; and
a radio circuit connected to the transistor circuit,
wherein, in a first frequency band, an output impedance of the antenna element is capacitive and an input impedance of the transistor circuit via the inductance circuit is inductive, and the output impedance of the antenna element and the input impedance of the transistor circuit via the inductance circuit are substantially in a complex conjugate relation,
in a second frequency band higher than the first frequency band, the output impedance of the antenna element is inductive and the input impedance of the transistor circuit via the inductance circuit is capacitive, and the output impedance of the antenna element and the input impedance of the transistor circuit via the inductance circuit are substantially in a complex conjugate relation.
